# EUROPEAN PATENT APPLICATION

(11) **EP 4 819 774 A1**
(43) Date of publication of application: **07.10.2026**
(21) Application number: 24897275.4
(22) Date of filing: 12.11.2024
(51) Int. Cl.: H05K 3/20

(54) **COMPOSITE BODY, METHOD FOR MANUFACTURING COMPOSITE BODY, LAMINATE, AND METHOD FOR MANUFACTURING LAMINATE**

(30) Priority: 27.11.2023 JP 2023199762
(71) Applicant: NHK Spring Co., Ltd., Yokohama-shi, Kanagawa 236-0004 (JP)
(72) Inventor: MIZUNO, Katsumi, Yokohama-shi, Kanagawa 236-0004 (JP); SHIMOMURA, Kohei, Yokohama-shi, Kanagawa 236-0004 (JP); TOGA, Takashi, Yokohama-shi, Kanagawa 236-0004 (JP)
(74) Representative: TBK
(86) International application number: PCT/JP2024/040094
(87) International publication number: WO 2025/115588

(57) **Abstract**

Proposed is a technique capable of ensuring insulating properties of an insulating layer constituting a laminate even in a case where a circuit pattern having a thickness of 0.5 mm or more is used.

A composite body (1) includes: an electrical member (2) including a circuit portion (2a) and a gap portion (2b), and having a thickness of 0.5 mm or more; and an elastic member (3) disposed on one surface side of the electrical member (2) in a state where a portion of the elastic member is received in the gap portion (2b).

## Description

### Technical Field

The present invention relates to a composite body, a method for manufacturing a composite body, and a method for manufacturing a laminate.

### Background Art

Conventionally, as a circuit board on which an electronic component such as a semiconductor chip is mounted, a laminate in which a metal base substrate, an insulating layer, and a circuit pattern are laminated is known (see, for example, Patent Literature 1). Such a laminate is produced according to steps of, for example, preparing a resin composition obtained by mixing a resin and a filler, applying the resin composition onto a metal base substrate and performing pre-curing, and disposing a circuit pattern on the resin composition and performing hot pressing.

In recent years, the opportunities to use electronic components such as high-luminance LEDs and power modules through which a large current flow is increasing. In order to obtain a laminate with which such an electronic component can be used in response to a large current, it is effective to increase the thickness of the circuit pattern to reduce a resistance value and ensure sufficient heat dissipation when the large current flows.

### Citation List

### Patent Literatures

| | |
|---|---|
| Patent Literature 1: | JP 2002-012653 A |
| Patent Literature 2: | JP 2009-206225 A |

### Summary of Invention

### Technical Problem

Moreover, in a case where hot pressing is carried out when the laminate is produced, the resin composition in contact with a conductive portion (metal portion) included in the circuit pattern is pressurized, while a gap portion located between the conductive portions adjacent to each other is not in contact with the resin composition. Therefore, the pressurization on the resin composition in the gap portion is likely to be insufficient. That is, when the hot pressing is carried out, the pressure is unevenly applied to the resin composition depending on whether the resin composition is in contact with the conductive portion or not. Here, at the site where the gap portion is disposed, a gas contained in the resin composition cannot be discharged because the pressurization is insufficient, and a large number of voids thus occurs, which may result in failure to ensure the insulating properties. As the thickness of the circuit pattern increases, the depth of this gap portion increases, and insufficient pressurization is thus more likely to occur. In particular, in a case where the circuit pattern has a thickness of 0.5 mm or more, the frequency of occurrence of such defects has increased. In addition, in such a laminate, a plurality of electronic components, each having relatively thick thickness, may be used instead of the circuit pattern. Also in a laminate using such electronic components, similarly to the above-described conductive portions, while the resin composition that is in contact with the plurality of electronic components is pressurized, gap portions located between adjacent electronic components are not in contact with the resin composition. Therefore, insufficient pressurization of the resin composition is likely to occur in these gap portions, and the frequency of occurrence of the above-described defects has been increasing.

In view of such problems, an object of the present invention is to provide a technique capable of ensuring the insulating properties of an insulating layer constituting a laminate, even in a case where a circuit pattern having a thickness of 0.5 mm or more or a plurality of electronic components is used. Note that, in the following description, the above-described circuit pattern and the plurality of electronic components are collectively referred to as an "electrical member", and the conductive portions in the circuit pattern and the electronic component are collectively referred to as a "circuit portion".

### Solution to Problem

The present invention is a composite body including: an electrical member including a circuit portion and a gap portion and having a thickness of 0.5 mm or more; and an elastic member disposed on one surface side of the electrical member in a state where a portion of the elastic member is received in the gap portion.

The above-described composite body preferably further includes a mesh sheet laminated on the portion of the elastic member received in the gap portion.

The above-described composite body preferably further includes a release film laminated on an other surface side of the electrical member with respect to the mesh sheet.

The release film preferably has a through-hole communicating with the mesh sheet.

In addition, the present invention is also a composite body including: an electrical member including a circuit portion and a gap portion, and having a thickness of 0.5 mm or more; an elastic member disposed on one surface side of the electrical member; and a pressure-sensitive adhesive layer laminated on an other surface side of the electrical member with respect to the elastic member.

In addition, the present invention is also a composite body including: an electrical member including a circuit portion and a gap portion, and having a thickness of 0.5 mm or more; an elastic member disposed on one surface side of the electrical member; a mesh sheet having a first opening corresponding to the circuit portion, and disposed on an other surface side of the elastic member in a state where the circuit portion is inserted through the first opening and received in the gap portion; and a release film having a second opening corresponding to the circuit portion, and disposed on an other surface side of the mesh sheet in a state where the circuit portion is inserted through the second opening and received in the gap portion.

The above-described composite body preferably further includes a pressure-sensitive adhesive layer disposed between the elastic member and the mesh sheet.

In addition, the present invention is also a method for manufacturing a composite body, the method including: a step of preparing an electrical member including a circuit portion and a gap portion, and having a thickness of 0.5 mm or more; a step of arranging an elastic member on one surface side of the electrical member; and a step of relatively pressing the elastic member against the electrical member in a state where surroundings are in a vacuum atmosphere and at a predetermined temperature, and allowing a portion of the elastic member to be received in the gap portion.

The above-described method for manufacturing a composite body preferably further includes: a step of preparing a mesh sheet having a first opening corresponding to the circuit portion; and a step of laminating the mesh sheet on an other surface side of the electrical member with respect to the elastic member, the laminating being performed before the step of allowing a portion of the elastic member to be received in the gap portion.

Furthermore, the above-described method for manufacturing a composite body preferably further includes: a step of preparing a release film having a second opening corresponding to the circuit portion; and a step of laminating the release film on the other surface side of the electrical member with respect to the mesh sheet, the laminating being performed before the step of allowing a portion of the elastic member to be received in the gap portion.

Furthermore, the above-described method for manufacturing a composite body preferably further includes a step of forming a through-hole in the release film at a location different from the second opening, the forming a through-hole being performed before the step of laminating the release film

In addition, the present invention is also a method for manufacturing a laminate in which a metal base substrate, an insulating layer formed by curing a resin composition, and an electrical member having a circuit portion and a gap portion and having a thickness of 0.5 mm or more are laminated, the method including: a step of laminating the resin composition in a semi-cured state on the metal base substrate; a step of laminating a composite body manufactured by the method for manufacturing a composite body according to any one of the above on the resin composition in a semi-cured state to prepare a pre-press-bonding laminate; a step of curing the resin composition in a semi-cured state in a state where surroundings of the pre-press-bonding laminate are in a vacuum atmosphere and at a predetermined temperature; and a step of removing at least the elastic member of the pre-press-bonding laminate to form the laminate.

In addition, the present invention is also a method for manufacturing a laminate in which a metal base substrate, an insulating layer formed by curing a resin composition, and an electrical member having a circuit portion and a gap portion and a thickness of 0.5 mm or more are laminated, the method including: a step of preparing a pre-press-bonding laminate in which the metal base substrate, the resin composition in a semi-cured state, the electrical member, a pressure-sensitive adhesive layer, and an elastic member are laminated in this order; a step of curing the resin composition in a semi-cured state in a state where surroundings of the pre-press-bonding laminate are in a vacuum atmosphere and at a predetermined temperature; and a step of removing at least the elastic member to form the laminate.

In addition, the present invention is also a method for manufacturing a laminate in which a metal base substrate, an insulating layer formed by curing a resin composition, and an electrical member including a circuit portion and a gap portion and having a thickness of 0.5 mm or more are laminated, the method including: a step of preparing a mesh sheet having a first opening corresponding to the circuit portion; a step of preparing a release film having a second opening corresponding to the circuit portion; a step of preparing a pre-press-bonding laminate in which the metal base substrate, the resin composition in a semi-cured state, the electrical member, the release film positioned at a position where the second opening is received in the circuit portion, the mesh sheet positioned at a position where the first opening is received in the circuit portion, and an elastic member are laminated in this order; a step of curing the resin composition in a semi-cured state in a state where surroundings of the pre-press-bonding laminate are in a vacuum atmosphere and at a predetermined temperature; and a step of removing at least the elastic member to form the laminate.

In the above-described method for manufacturing a laminate, it is preferable that the pre-press-bonding laminate further includes a pressure-sensitive adhesive layer disposed between the elastic member and the mesh sheet.

### Advantageous Effects of Invention

According to the composite body, the method for manufacturing the composite body, and the method for manufacturing a laminate of the present invention, it is possible to ensure the insulating properties of the insulating layer constituting the laminate even in a case where the electrical member having a thickness of 0.5 mm or more is used.

### Brief Description of Drawings

Fig. 1 is a diagram illustrating a composite body manufactured by a method for manufacturing a composite body according to an embodiment of the present invention.
Fig. 2 is a diagram illustrating a laminate manufactured by a method for manufacturing a laminate according to an embodiment of the present invention.
Fig. 3 is a diagram illustrating the flow of the method for manufacturing a composite body according to the embodiment of the present invention.
Fig. 4 is a diagram relating to the method for manufacturing a composite body according to the embodiment of the present invention.
Fig. 5 is a diagram illustrating the flow of the method for manufacturing a laminate according to the embodiment of the present invention.
Fig. 6A is a diagram illustrating an example of an autoclave used in the method for manufacturing a laminate according to the embodiment of the present invention.
Fig. 6B is a partially enlarged view of a portion A illustrated in Fig. 6A.
Fig. 7A is a diagram illustrating the configuration of a comparative example of a composite body used in a confirmation test of a laminate.
Fig. 7B is a diagram illustrating the configuration of Test Example 1 of a composite body used in a confirmation test of a laminate.
Fig. 7C is a diagram illustrating the configuration of Test Example 2 of a composite body used in a confirmation test of a laminate.
Fig. 7D is a diagram illustrating the configuration of Test Example 3 of a composite body used in a confirmation test of a laminate.
Fig. 7E is a diagram illustrating the configuration of Test Example 4 of a composite body used in a confirmation test of a laminate.
Fig. 7F is a diagram illustrating the configurations of Test Examples 5 and 6 of composite bodies used in a confirmation test of a laminate.
Fig. 7G is a diagram illustrating the configuration of Test Example 7 of a composite body used in a confirmation test of a laminate.
Fig. 8 is a diagram illustrating a modification of an assembly body illustrated in Fig. 1.
Fig. 9A is a diagram (cross-sectional diagram in side view) illustrating a modification of the laminate illustrated in Fig. 2.
Fig. 9B is a plan view of Fig. 9A.

### Description of Embodiments

Hereinafter, an embodiment of a composite body, a method for manufacturing a composite body, and a method for manufacturing a laminate according to the present invention will be described with reference to the accompanying drawings. The figures are schematically illustrated in the accompanying drawings, and the thickness and width of each portion, the ratio between the portions, and other parameters may be different from those actually implemented. In addition, in the following description, for convenience, description will be given with reference to the illustrated direction; however, the direction does not limit a direction during manufacturing or using the composite body or the laminate according to the present invention. That is, for example, even in a case where it is described that one member is laminated on a lower surface of the other member, such description does not limit the manufacturing direction, and laminating the two members in a state where the illustrated configuration is inverted vertically is also included in the present invention. In addition, the present invention also includes the use of the composite body or the laminate in a state where the illustrated configuration is inverted vertically.

In the Japanese Industrial Standards, a "sheet" refers to a thin, flat product having a thickness that is small relative to its length and width, whereas a "film" refers to a thin, flat product having a thickness that is extremely small relative to its length and width and having a maximum thickness limited to a predetermined value, and is usually supplied in the form of a roll (JIS K 6900). However, the boundary between a sheet and a film is not clearly defined in general, and even in a case where it is referred to as a "film", a "sheet" may be included, and even in a case where it is referred to as a "sheet", a "film" may be included. Accordingly, in the present invention, a "film" is intended to include a "sheet", and a "sheet" is intended to include a "film".

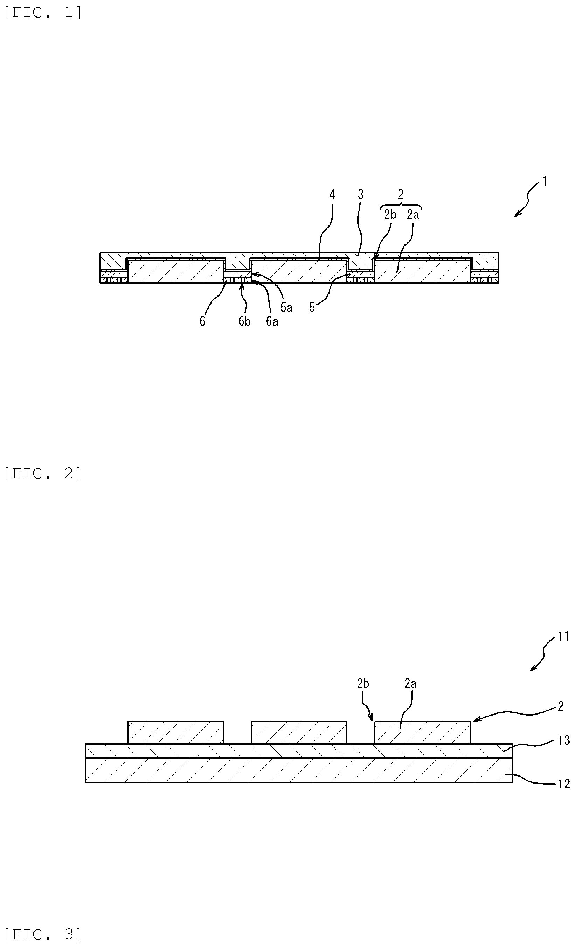

Fig. 1 is a diagram illustrating a composite body 1 manufactured by a method for manufacturing a composite body according to the present embodiment. The composite body 1 includes a circuit pattern 2, an elastic member 3, a pressure-sensitive adhesive layer 4, a mesh sheet 5, and a release film 6. The circuit pattern 2 is a type of "electrical member" in the present specification and the like.

Fig. 2 is a diagram illustrating a laminate 11 manufactured by a method for manufacturing a laminate according to the present embodiment. The laminate 11 includes a metal base substrate 12, an insulating layer 13, and a circuit pattern 2. Note that the circuit pattern 2 included in the laminate 11 is provided using the above-described composite body 1.

The circuit pattern 2 is obtained by forming a predetermined pattern using a material having conductivity. Examples of such a material include a metal sheet made of copper or aluminum. The thickness of the metal sheet (the thickness of the circuit pattern 2) is 0.5 mm or more. Note that the upper limit of the thickness of the metal sheet (the thickness of the circuit pattern 2) is not particularly limited, but is, for example, 2.0 mm or less. Examples of a method for forming a predetermined pattern by using a metal sheet include a method for forming a mask pattern on a metal sheet to remove an exposed portion of the metal sheet by etching, and a method for punching a metal sheet by using a mold. Here, a metal portion in the circuit pattern 2 is referred to as a conductive portion 2a, and a portion formed as a gap by removing the metal is referred to as a gap portion 2b. The conductive portion 2a is a type of "circuit portion" in the present specification and the like.

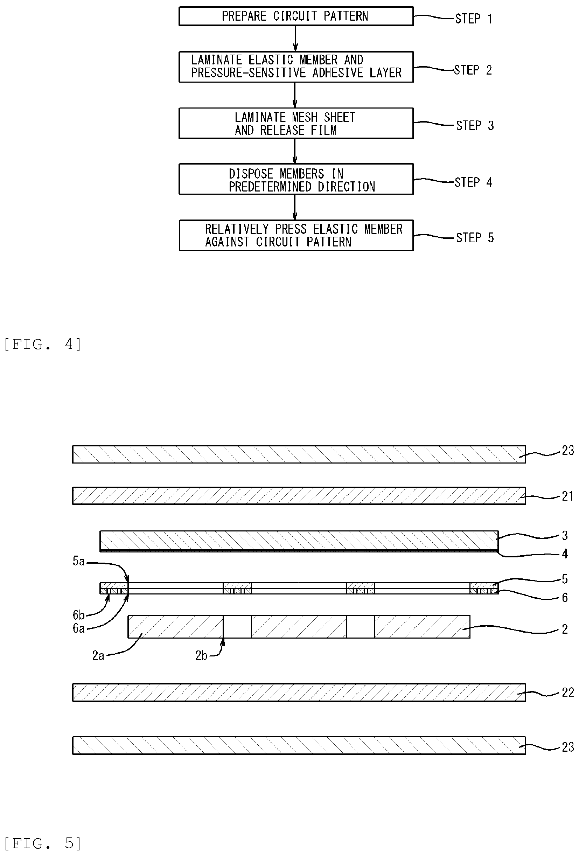

The elastic member 3 is a member that exhibits elastic force when pressed, and is formed of, for example, a thermoplastic elastomer such as a urethane-based, ester-based, styrene-based, olefin-based, butadiene-based, or fluorine-based thermoplastic elastomer, or a thermosetting elastomer such as urethane rubber, silicone rubber, isoprene rubber, ethylene propylene rubber, natural rubber, ethylene propylene diene rubber, nitrile rubber (NBR), or styrene butadiene rubber (SBR). The elastic member 3 may be solid having no cavity therein, or may be porous having cavities therein (for example, a sponge or a foam). In addition, the cavities may be continuous with each other within the elastic member 3 or may be isolated from each other. The elastic member 3 of the present embodiment is a polyurethane foam. Before being configured as the composite body 1, the elastic member 3 has a sheet shape as illustrated in Fig. 4, and has a thickness of, for example, 1 to 10 mm. The elastic member 3 of the present embodiment is formed to be slightly larger than the circuit pattern 2, and as illustrated in Fig. 1, an outer edge portion of the elastic member 3 extends to an outer side of the conductive portion 2a included in the circuit pattern 2.

The pressure-sensitive adhesive layer 4 has pressure-sensitive adhesiveness with respect to metal, and is formed of, for example, a urethane-based, acrylic-based, silicone-based pressure-sensitive adhesive, or the like. Note that, in the present embodiment, the pressure-sensitive adhesive layer 4 that has relatively low pressure-sensitive adhesiveness with respect to a resin composition (for example, an epoxy resin) described later for forming the insulating layer 13 is used. Specifically, a composite layer composed of an acrylic resin layer formed of an acrylic-based pressure-sensitive adhesive and a silicone resin layer formed of a silicone-based pressure-sensitive adhesive (the acrylic resin layer being positioned on the elastic member 3 side) is used as the pressure-sensitive adhesive layer 4. While the silicone resin layer has low pressure-sensitive adhesiveness with respect to the polyurethane foam used for the elastic member 3 in the present embodiment, the acrylic resin layer has high pressure-sensitive adhesiveness; therefore, the pressure-sensitive adhesive layer 4 can adhere to the elastic member 3. The pressure-sensitive adhesive strength of the pressure-sensitive adhesive layer 4 (in the present embodiment, the pressure-sensitive adhesive strength of the silicone resin layer) is, for example, 1 to 1000 mN/10 mm (in accordance with JIS Z 1528, measured as a force when attached to a stainless steel plate and pulled at a peel angle of 180° and a speed of 300 mm/min). In addition, the thickness of the pressure-sensitive adhesive layer 4 is, for example, 5 to 200 µm. The pressure-sensitive adhesive layer 4 may be provided on the elastic member 3 by preparing the preparation of a pressure-sensitive adhesive sheet obtained by applying a pressure-sensitive adhesive to a releasable sheet, attaching the pressure-sensitive adhesive sheet to a lower surface of the sheet-shaped elastic member 3 illustrated in Fig. 4, and then removing the sheet. Alternatively, the pressure-sensitive adhesive layer 4 may be provided on the elastic member 3 by applying a pressure-sensitive adhesive to a surface of the elastic member 3. In addition, the pressure-sensitive adhesive layer 4 may be a single layer (for example, only an acrylic resin layer or only a silicone resin layer) or may be a multilayer.

The mesh sheet 5 is, for example, a sheet in which fibers made of a synthetic resin are arranged to form a mesh. Examples of such a sheet include a woven fabric, a net fabric, and a nonwoven fabric. The melting point of the synthetic resin fibers used for the mesh sheet 5 is preferably relatively high, and is, for example, 200°C or higher. In a case where the melting point is low, the fibers may be fused when step 5 described later is performed, thereby impairing the air permeability of the mesh sheet 5. In addition, the thickness of the mesh sheet 5 is, for example, 100 to 200 µm. In the present embodiment, the mesh sheet 5 is formed to be slightly larger than the circuit pattern 2, and as illustrated in Fig. 1, an outer edge portion of the mesh sheet 5 extends to an outer side of the conductive portion 2a included in the circuit pattern 2. Then, as illustrated in Fig. 4, the mesh sheet 5 is provided with an opening (a first opening 5a) corresponding to the conductive portion 2a.

The release film 6 is a synthetic resin film having peelability imparted to one surface or both surfaces thereof. In the present embodiment, peelability is imparted to one surface of the synthetic resin film (a lower surface of the release film 6 illustrated in Fig. 4). Examples of such a release film 6 include a synthetic resin film surface-treated with a release agent such as a silicone-based release agent or a non-silicone-based release agent, for example, a long-chain alkyl-based resin or an olefin-based resin. In addition, the thickness of the release film 6 is, for example, 10 to 200 µm. In the present embodiment, the release film 6 is formed to be slightly larger than the circuit pattern 2, and as illustrated in Fig. 1, an outer edge portion of the release film 6 extends to an outer side of the conductive portion 2a included in the circuit pattern 2. Then, as illustrated in Fig. 4, the release film 6 is provided with an opening (second opening 6a) corresponding to the conductive portion 2a, and a through-hole 6b is further provided at a location different from the second opening 6a.

Then, the metal base substrate 12 is formed of, for example, a metal such as copper, aluminum, or iron (may be a single-component metal or an alloy). The metal base substrate 12 may have a single layer structure or a multilayer structure, or may be formed of a single member or a combination of a plurality of members. The metal base substrate 12 of the present embodiment may be sheet-shaped, but may be a heat sink provided with comb-shaped fins. In addition, the metal base substrate 12 may have a configuration that improves an effect of releasing heat to the outside, and for example, may have a configuration in which a vapor chamber or a heat pipe is embedded in the metal sheet.

The insulating layer 13 is formed of a material having insulating properties, and is provided to cover a surface of the metal base substrate 12. The insulating layer 13 may cover the entire surface of the metal base substrate 12 or may cover a portion of the surface.

The insulating layer 13 is formed of a resin composition containing a thermosetting resin. Examples of the thermosetting resin include an epoxy resin, a phenol resin, a melamine resin, a urea resin, an unsaturated polyester resin, an alkyd resin, a cyanate resin, and other resins. The thermosetting resin may be used alone, or two or more kinds thereof may be used in combination.

As the epoxy resin, regardless of a molecular weight and a molecular structure thereof, it is possible to use any of a monomer, an oligomer, or a polymer, which has two or more epoxy groups in one molecule. Specific examples of such an epoxy resin include bisphenol epoxy resins such as bisphenol A epoxy resins, bisphenol F epoxy resins, bisphenol E epoxy resins, bisphenol S epoxy resins, hydrogenated bisphenol A epoxy resins, bisphenol M epoxy resins (4,4'-(1,3-phenylenediisoplidiene) bisphenol epoxy resins), bisphenol P epoxy resins (4,4'-(1,4-phenylenediisoplidiene) bisphenol epoxy resins), bisphenol Z epoxy resins (4,4'-cyclohexydiene bisphenol epoxy resins); novolac epoxy resins such as phenol novolac epoxy resins, brominated phenol novolac epoxy resins, cresol novolac epoxy resins, tetraphenol group ethane novolac epoxy resins, and novolac epoxy resins having a fused ring aromatic hydrocarbon structure; biphenyl epoxy resins; aralkyl epoxy resins such as xylylene epoxy resins and biphenyl aralkyl epoxy resins; epoxy resins having a naphthalene skeleton such as naphthylene ether epoxy resins, naphthol epoxy resins, naphthalene epoxy resins, naphthalene diol epoxy resins, bifunctional or tetrafunctional epoxy naphthalene resins, binaphthyl epoxy resins, and naphthalene aralkyl epoxy resins; anthracene epoxy resins; phenoxy epoxy resins; dicyclopentadiene epoxy resins; norbornene epoxy resins; adamantane epoxy resins; heterocyclic epoxy resins such as fluorene epoxy resins, phosphorus-containing epoxy resins, alicyclic epoxy resins, aliphatic linear epoxy resins, bisphenol A novolac epoxy resins, bixylenol epoxy resins, triphenolmethane epoxy resins, trihydroxyphenylmethane epoxy resins, tetraphenylolethane epoxy resin, and triglycidyl isocyanurate; glycidyl amines such as N,N,N',N'-tetraglycidyl meta-xylene diamine, N,N,N',N'-tetraglycidyl bisaminomethylcyclohexane, and N,N-diglycidyl aniline, copolymers of glycidyl (meth)acrylate and compounds having ethylenically unsaturated double bonds, epoxy resins having a butadiene structure, diglycidyl ethers of bisphenols, diglycidyl ethers of naphthalenediol, and glycidyl ethers of phenols, and the like. The epoxy resin may be used alone, or two or more kinds thereof may be used in combination.

The resin composition of the present embodiment is blended with a curing agent. The curing agent is not particularly limited as long as it is selected according to the type of thermosetting resin and reacts with the thermosetting resin. Examples of the curing agent in a case of using an epoxy resin include an amine-based curing agent, an imidazole-based curing agent, and a phenol-based curing agent.

The resin composition of the present embodiment is also blended with a filler (inorganic filler). The filler preferably has excellent insulating properties and high thermal conductivity, and examples thereof include aluminum oxide, silica, aluminum nitride, boron nitride, silicon nitride, magnesium oxide, and the like. The filler may be used alone, or two or more kinds thereof may be used in combination.

The resin composition of the present embodiment is further blended with a curing accelerator. The curing accelerator is not particularly limited, and examples thereof include organometallic salts such as benzoxazine compounds, borate complexes, zinc naphthenate, cobalt naphthenate, tin octylate, cobalt octylate, bisacetylacetonate cobalt (II), and triacetylacetonate cobalt (III); phenol compounds such as phenol, bisphenol A, and nonylphenol; tertiary amines, tertiary amine salts, phosphines, and phosphonium salts.

The resin composition of the present embodiment is also blended with a solvent. The solvent is not particularly limited, and examples thereof include N-methylpyrrolidone, dimethylacetamide, tetrafluoroisopropanol, methyl ethyl ketone, ethylene diglycol acetate, propylene glycol monomethyl ether acetate, methyl isobutyl ketone, ethylene glycol monomethyl ether, tetrahydrofuran, chloroform, toluene, xylene, acetone, dioxane, and dimethyl sulfoxide.

The resin composition may contain an additive. Examples of additives include a stabilizer, an ion scavenger, and a flexibility-imparting agent.

Next, a method for manufacturing the composite body 1 will be described with reference to Figs. 2 and 3. Note that, in the following description, step 1, step 2, and so on will be described in this order; however, the present invention is not limited to being carried out in this order, and the order may be changed within a range in which each step is established, or the respective steps may be carried out simultaneously.

First, step 1 illustrated in Fig. 2 is carried out. In step 1, a circuit pattern 2 is prepared. In this step, the circuit pattern 2 including a conductive portion 2a and a gap portion 2b is formed using a technique such as etching described above.

In step 2, an elastic member 3 and a pressure-sensitive adhesive layer 4 are laminated. In the present embodiment, the sheet-shaped elastic member 3 is prepared as illustrated in Fig. 4. Then, for example, using a method of preparing a pressure-sensitive adhesive sheet obtained by applying a pressure-sensitive adhesive to a releasable sheet, attaching the pressure-sensitive adhesive sheet to the elastic member 3, and removing the sheet, the elastic member 3 and the pressure-sensitive adhesive layer 4 are laminated.

Then, in step 3, a mesh sheet 5 and a release film 6 are laminated. In the present embodiment, both the mesh sheet 5 and the release film 6 are laminated by interposing a pressure-sensitive adhesive layer between the mesh sheet 5 and the release film 6. Specifically, through the preparation of the pressure-sensitive adhesive sheet formed by applying an acrylic pressure-sensitive adhesive to a PET sheet to form a pressure-sensitive adhesive layer, the mesh sheet 5 is attached to this pressure-sensitive adhesive sheet to transfer the pressure-sensitive adhesive layer to the mesh sheet 5, whereupon the mesh sheet 5 carrying the transferred pressure-sensitive adhesive layer is adhered to a non-peeling surface of the release film 6 (the upper surface of the release film 6 illustrated in Fig. 4). Alternatively, the pressure-sensitive adhesive layer may be transferred to the release film 6 and laminated with the mesh sheet 5. In addition, the first opening 5a and the second opening 6a may be provided in the mesh sheet 5 and the release film 6 before the mesh sheet 5 is attached to the release film 6, or may be provided by performing a process of penetrating both in a thickness direction after the mesh sheet 5 is attached to the release film 6. The through-hole 6b is preferably provided in the release film 6 before the mesh sheet 5 and the release film 6 are laminated. The shape of the first opening 5a provided in the mesh sheet 5 and the shape of a portion connecting adjacent first openings 5a are basically corresponding to the shape of the conductive portion 2a and the shape of the gap portion 2b (the same applies to the shape of the second opening 6a provided in the release film 6 and the shape of a portion connecting adjacent second openings 6a); however, it is not necessary to achieve complete match. For example, with respect to the gap portion 2b located between two conductive portions 2a, when the gap of the gap portion 2b is narrow, a width of a portion connecting adjacent first openings 5a also decreases, which may hinder the formation of such a connecting portion. In such a case, a single opening that entirely surrounds the two conductive portions 2a may be provided as the first opening 5a.

In step 4, the circuit pattern 2, a laminated structure of the elastic member 3 and the pressure-sensitive adhesive layer 4, and a laminated structure of the mesh sheet 5 and the release film 6 are disposed in a predetermined direction. In the present embodiment, as illustrated in Fig. 4, the laminated structure of the elastic member 3 and the pressure-sensitive adhesive layer 4 is disposed such that an upper surface of the circuit pattern 2 faces the pressure-sensitive adhesive layer 4, and the laminated structure of the mesh sheet 5 and the release film 6 is arranged in a direction in which the pressure-sensitive adhesive layer 4 faces the mesh sheet 5. Note that the laminated structure of the elastic member 3 and the pressure-sensitive adhesive layer 4 is disposed with respect to the circuit pattern 2 at a position where the first opening 5a and the second opening 6a are inserted through the conductive portion 2a. Furthermore, a cushion material 21, a resin sheet 22, and a metal plate 23 illustrated in Fig. 4 are also disposed as illustrated. Here, the cushion material 21 is used for the purpose of facilitating the elastic member 3 to be pushed into the gap portion 2b in a step described later. In addition, the resin sheet 22 is used for the purpose of protecting a lower surface of the conductive portion 2a. Note that, in Fig. 4, although each member is illustrated as having a gap therebetween in a vertical direction, the respective members are actually in contact with each other in the vertical direction. In this case, since the circuit pattern 2 and the mesh sheet 5 are attached to the pressure-sensitive adhesive layer 4, positional displacement thereof can be prevented.

In step 5, the elastic member 3 is relatively pressed against the circuit pattern 2 in a state where surroundings are in a vacuum atmosphere and at a predetermined temperature. In the present embodiment, after the respective members illustrated in Fig. 4 are disposed inside a vacuum press apparatus in the illustrated arrangement, the inside of the apparatus is evacuated to establish a vacuum atmosphere, and one of the metal plate 23 is pressed toward the other metal plate 23 for a predetermined time using a hot plate. Note that the temperature of the hot plate is 100°C to 300°C, the pressing force is 0.1 to 20 MPa, and the pressing time is 0.5 to 20 minutes.

By carrying out steps 1 to 5 as described above, the elastic member 3 is pressed into the gap portion 2b and to an outer side of the conductive portion 2a, and as illustrated in Fig. 1, the composite body 1 can be manufactured in which a portion of the elastic member 3 enters the gap portion 2b and the outer side of the conductive portion 2a (in the present embodiment, a portion of the pressure-sensitive adhesive layer 4 also enters together with the elastic member 3). When a portion of the elastic member 3 is received in the gap portion 2b and an outer side of the conductive portion 2a, an upper surface of the elastic member 3 in a peripheral region of the gap portion 2b and the outer side of the conductive portion 2a may be locally recessed, which may result in insufficient pressing into the gap portion 2b and the outer side of the conductive portion 2a. However, in the present embodiment, since the elastic member 3 is pressed via the cushion material 21, a portion of the elastic member 3 can be sufficiently caused to be received the gap portion 2b and the outer side of the conductive portion 2a. In addition, since the lower surface of the conductive portion 2a is covered by the resin sheet 22, the lower surface of the conductive portion 2a can be protected even in a case where the elastic member 3 is relatively pressed against the circuit pattern 2. Note that the thickness of the elastic member 3 that has been received in the gap portion 2b and the outer side of the conductive portion 2a (in the present embodiment, the thickness of the elastic member 3 including the pressure-sensitive adhesive layer 4) is preferably 10 to 100% of the depth of the gap portion 2b (the thickness of the circuit pattern 2), more preferably 30 to 100%, and still more preferably 50 to 100%.

In the present embodiment, before performing step 5, the mesh sheet 5 and the release film 6 are laminated on the sheet-shaped elastic member 3 provided with the pressure-sensitive adhesive layer 4. However, step 5 may be performed without laminating the mesh sheet 5 and the release film 6, and thereafter the laminated structure of the elastic member 3 and the pressure-sensitive adhesive layer 4 may be laminated on a portion of the elastic member 3 that has been received in the gap portion 2b (or the mesh sheet 5 and the release film 6 may be laminated in this order).

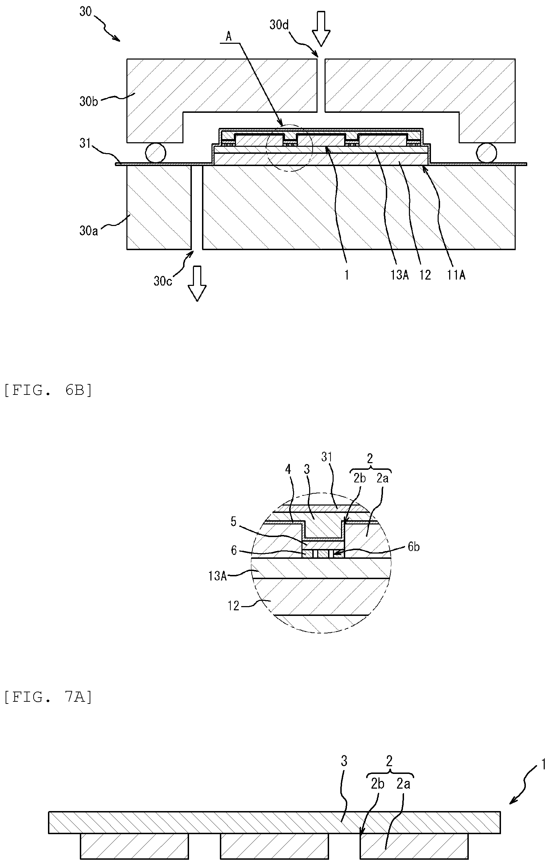

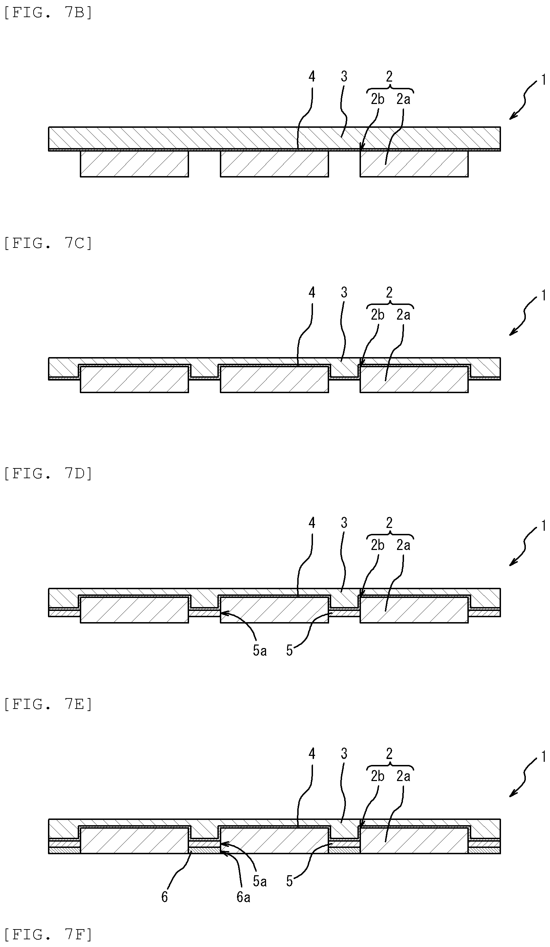

Note that the composite body 1 may have the configurations illustrated in Figs. 7B to 7E. That is, as illustrated in Fig. 7B, a configuration in which the elastic member 3 and the pressure-sensitive adhesive layer 4 are laminated, and this laminated structure is laminated on the circuit pattern 2 while remaining in a sheet shape; as illustrated in Fig. 7C, a configuration in which a portion of the elastic member 3 and pressure-sensitive adhesive layer 4 is received in the gap portion 2b; as illustrated in Fig. 7D, a configuration in which a portion of the elastic member 3 and pressure-sensitive adhesive layer 4 is received in the gap portion 2b and the mesh sheet 5 is further laminated; and as illustrated in Fig. 7E, a configuration in which a portion of the elastic member 3 and pressure-sensitive adhesive layer 4 is received in the gap portion 2b and the mesh sheet 5 and the release film 6 (without the through-hole 6b) are further laminated are also included in the present invention.

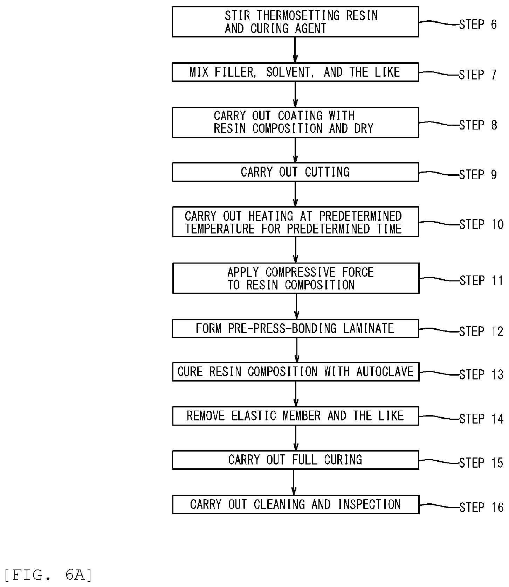

Next, a method for manufacturing the laminate 11 using the composite body 1 will be described with reference to Figs. 5, 6A, and 6B.

First, step 6 illustrated in Fig. 5 is carried out. In step 6, a thermosetting resin and a curing agent are placed in a container and stirred at a predetermined temperature for a predetermined time. As a result, the thermosetting resin and the curing agent can react with each other. Depending on the temperature during the stirring and the stirring time, the thermosetting resin and the curing agent that react with each other in step 6 can be brought in a prepolymer state, but this process may be appropriately selected depending on the curing degree of the thermosetting resin in a step described later, and it is not always necessary to bring the thermosetting resin and the curing agent in a prepolymer state in step 6.

In step 7, the stirred thermosetting resin is mixed with the curing agent, the filler, the curing accelerator, and the solvent to produce a resin composition. Note that the resin composition in step 7 is in a semi-cured state.

In step 8, a surface of a thin base material is coated with the produced resin composition, and drying is further performed to volatilize the solvent. The base material is not particularly limited as long as it can be peeled off from the resin composition in a step described later, and as an example, an elongated PET sheet can be used. In addition, although there is no particular limitation in carrying out step 8, in a case of using an apparatus including a supply unit that supplies an elongated base material, a coating unit that is provided at downstream in a supplying direction and coats a surface of the base material with the resin composition, and a heating unit that is provided at upstream in the supplying direction and heats the resin composition passing through the heating unit at a predetermined temperature, the coating and drying can be continuously performed on the resin composition, and it is thus excellent in that step 8 can be carried out efficiently.

In step 9, the elongated base material coated with the resin composition is cut into a predetermined size to form a single sheet material in which the resin composition and the base material are laminated. In a case where a base material cut into a predetermined size in advance in step 8 is used, step 9 can be omitted.

In step 10, the resin composition with which the base material is coated is heated at a predetermined temperature for a predetermined time. Accordingly, a molecular weight (weight-average molecular weight) of the semi-cured resin composition can be increased. Although the molecular weight of the resin composition is also increased in step 10 and the subsequent steps, the total time required for producing the laminate 11 can be shortened by increasing the molecular weight of the resin composition in advance in step 10. In addition, in a case where the required molecular weight of the resin composition in any step is already obtained before step 10, step 10 may be omitted. A specific example for carrying out step 10 includes preparing a plurality of sheet materials each of which is formed by lamination of the resin composition and the base material described above, and heating the plurality of sheet materials together in a heating furnace.

In step 11, a compressive force is applied to the resin composition in a semi-cured state. The resin composition before carrying out step 11 is in a state of containing a large number of voids therein because of drying in step 8, but step 11 enables an increase in the density to reduce the voids, and furthermore, enables the resin composition to be formed as an insulating layer with high insulating properties through a step described later. A specific example for carrying out step 11 includes overlaying the above-described sheet material onto the metal base substrate 12 illustrated in Fig. 1 so that the resin composition is in contact with the metal base substrate 12, placing those inside a vacuum press device, and pressing the overlaid metal base substrate 12 and sheet material in a state where the inside of this device is in a vacuum atmosphere at a predetermined temperature. Accordingly, the resin composition in a semi-cured state can be transferred to the metal base substrate 12, and a compressive force can be applied to the resin composition. Note that the metal base substrate 12 is not necessarily required to perform step 11, and for example, a separately prepared base material and the above-described sheet material may be overlaid and pressed, or a single sheet material may be pressed.

Although a gas can be discharged from the resin composition in a semi-cured state by carrying out a step (step 13) with an autoclave described later, as a result of studies by the inventors of the present application, the gas may not be sufficiently discharged from the resin composition even though step 13 is carried out in a case where the curing of the resin composition proceeds too much. In addition, even though step 13 is performed in a state where the density of the resin composition is low, and a large number of voids are contained therein, it may be difficult to reduce the voids to such an extent that a sufficient withstand voltage can be obtained. In view of the above description, as a result of exhaustive studies for an optimal range of the molecular weight (weight-average molecular weight) and the density of the resin composition, the good result was obtained in a case where an increasing proportion of the weight-average molecular weight of the resin composition after step 11 (after the application of compressive force) was 30% or less based on before step 11 (before the application of compressive force). Furthermore, as a result of exhaustive studies on the increasing proportion of the weight-average molecular weight of the resin composition, a more preferable result was obtained in a case where the increasing proportion was 25% or less, and a still more preferable result was obtained in a case where the increasing proportion was 20% or less. In addition, a good result was obtained in a case where the density of the resin composition after step 11 (after application of compressive force) was 85% or more based on the actual density of the finally formed insulating layer. Furthermore, as a result of exhaustive studies on the density of the resin composition, a more preferable result was obtained in a case where the density was 90% or more, and a still more preferable result was obtained in a case where the density was 95% or more. Note that the weight-average molecular weight is a value in terms of polystyrene measured by a gel permeation chromatography (GPC) method.

In step 12, the base material is peeled off from the resin composition in a semi-cured state transferred to the metal base substrate 12, or in a case where the resin composition is not transferred to the metal base substrate 12, the resin composition is transferred, followed by peeling off the base material from the resin composition. The composite body 1 illustrated in Fig. 1 is then overlaid on the resin composition to form a pre-press-bonding laminate 11A (see Fig. 6A). In this step, the composite body 1 overlaid on the resin composition may be hot-pressed to temporarily bond the composite body 1 to the resin composition. Note that reference numeral 13A illustrated in Fig. 6A denotes the resin composition in a semi-cured state.

In step 13, for example, the resin composition 13A in a semi-cured state, which is laminated over the pre-press-bonding laminate 11A, is cured by using an autoclave 30 and a film (bagging film) 31 having such a configuration as illustrated in Fig. 6A. The autoclave 30 of the present embodiment includes a main body 30a and a lid body 30b. The main body 30a is provided with an exhausting passage 30c, and the lid body 30b is provided with a pressurizing passage 30d. Note that both or any one of the main body 30a or the lid body 30b is provided with a heater or other component that increases the temperature inside the autoclave 30. The film 31 is preferably a fluorine-based resin film having flexibility and excellent peelability. In addition, in the performing this step, the present invention is not limited to the case of using only the film 31, and a cushion material or breather cloth may be used together with the film 31.

In step 13, the pre-press-bonding laminate 11A is placed on the main body 30a and covered with the film 31, the lid body 30b is closed, and the film 31 is sandwiched between the main body 30a and the lid body 30b. Next, the inside atmosphere of the film 31 is exhausted by performing suction through the exhausting passage 30c, and the pressurized gas (air, nitrogen, or other gas) is sent through the pressurizing passage 30d to increase the pressure inside the autoclave 30, and the temperature inside the autoclave 30 is further increased by the heater. Then, this state can be maintained for a predetermined time to cure the resin composition 13A in a semi-cured state.

When performing step 13, the pressure inside the autoclave 30 is preferably 1 MPa or more and 3.0 MPa or less, the temperature inside the autoclave 30 is preferably 150°C to 200°C, and a time for maintaining the increased pressure and temperature is preferably 1 to 30 minutes. Note that the pressure and temperature inside the autoclave 30 can be changed for the purpose of allowing the curing of the resin composition 13A to appropriately proceed, and may be set to be constantly maintained during the above time, or may be set to change over time.

By performing step 13, the film 31 comes into close contact with an outer surface of the pre-press-bonding laminate 11A, and pressure is applied thereto. At this time, the elastic member 3 that is in contact with the film 31 is also pressed, and the elastic member 3 is pushed into the gap portion 2b. Accordingly, the resin composition 13A in contact with the circuit pattern 2 is pressed not only at the conductive portion 2a via the elastic member 3, but also by a portion of the elastic member 3 that has been pushed into the gap portion 2b. That is, since the pressure inside the autoclave 30 is applied over the entire region of the resin composition 13A, the gas (gas contained in the voids and the residual solvent, volatile low molecular weight component, gas generated in association with an effect reaction, and the like) can be discharged from the entire region of the resin composition 13A. In particular, in the present embodiment, a portion of the elastic member 3 has been received in the gap portion 2b before performing step 13. In addition, the mesh sheet 5 and the release film 6 are laminated on the portion of the elastic member 3 received in the gap portion 2b. Accordingly, since pressing at the gap portion 2b can be performed more effectively, the gas can be discharged from the resin composition 13A more effectively.

Since the release film 6 is provided with the through-hole 6b in the present embodiment, the gas discharged from the resin composition 13A is discharged through the through-hole 6b without accumulating between the release film 6 and the resin composition 13A. Here, the release film 6 is laminated with the mesh sheet 5, and the through-hole 6b communicates with the mesh sheet 5. That is, since the mesh sheet 5 has high air permeability, the gas discharged from the resin composition 13A through the through-hole 6b can be efficiently discharged to the outside of the pre-press-bonding laminate 11A.

Then, in step 14, the elastic member 3 and the like are removed from the laminate 11 in which the elastic member 3 and the like remain. In the present embodiment, the release film 6 is in contact with the resin composition 13A at a location where the gap portion 2b is positioned. However, since a lower surface of the release film 6 has releasability, the release film 6 can be favorably peeled from the resin composition 13A. Accordingly, the mesh sheet 5 and the elastic member 3 provided with the pressure-sensitive adhesive layer 4 can be removed together with the release film 6 from the laminate 11. Note that, since the mesh sheet 5 and the release film 6 are laminated on the gap portion 2b, the elastic member 3 does not usually come into contact with the resin composition 13A. However, depending on positioning accuracy when manufacturing the composite body 1 and a pressing state in the autoclave 30, the elastic member 3 may come into contact with the resin composition 13A. Here, in a case where the pressure-sensitive adhesive layer 4 is not laminated on the elastic member 3, the elastic member 3 may adhere to the resin composition 13A due to contact therebetween. However, since the pressure-sensitive adhesiveness of the pressure-sensitive adhesive layer 4 in the present embodiment is relatively low with respect to the resin composition 13A, the elastic member 3 can be removed without any problem even in such a case.

In step 15, the laminate 11 taken out from the autoclave 30 is then fully cured. A specific example for carrying out step 15 includes putting the laminate 11 taken out from the autoclave 30 in a heating furnace and heating the laminate 11 at a predetermined temperature for a predetermined time. Accordingly, the resin composition 13A in a semi-cured state can be fully cured. Note that step 15 is carried out in a case where the resin composition 13A is not fully cured in step 13, and step 15 is omitted in a case where the resin composition 13A is fully cured in step 13. In addition, step 14 of removing the elastic member 3 and the like may be performed after step 15.

In step 16, the laminate 11 in which the resin composition 13A is fully cured to form the insulating layer 13 is cleaned, and various inspections are performed.

Upon examining the laminate 11 manufactured through the above steps, it was confirmed, as described later, that the laminate 11 has high withstand voltage. In addition, even though the laminate 11 was repeatedly heated, peeling off between the insulating layer 13 and the circuit pattern 2 was not observed, and the result was good.

Hereinafter, a confirmation test performed to confirm the effect according to the present invention will be described. Note that the present invention is not limited to the conditions in the following confirmation test.

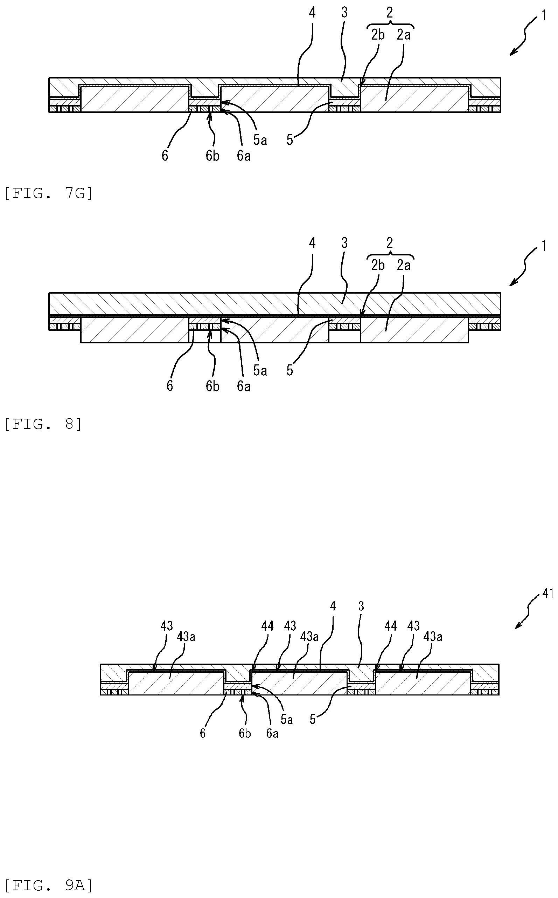

First, as the composite body 1, a comparative example for comparison with the present invention and Test Examples 1 to 7 according to the present invention were prepared. Here, the comparative example is an example in which, as illustrated in Fig. 7A, a sheet-shaped elastic member 3 (without the pressure-sensitive adhesive layer 4) is laminated on the circuit pattern 2. In addition, Test Example 1 is an example in which, as illustrated in Fig. 7B, the elastic member 3 and the pressure-sensitive adhesive layer 4 are laminated, and the laminated structure is laminated on the circuit pattern 2 while remaining in a sheet shape. Test Example 2 is an example in which step 5 was performed in a state where the circuit pattern 2, the elastic member 3, and the pressure-sensitive adhesive layer 4 were laminated, as illustrated in Fig. 7C. Test Example 3 is an example in which step 5 was performed in a state where the circuit pattern 2, the elastic member 3, the pressure-sensitive adhesive layer 4, and the mesh sheet 5 were laminated, as illustrated in Fig. 7D. Test Example 4 is an example in which step 5 was performed in a state where the circuit pattern 2, the elastic member 3, the pressure-sensitive adhesive layer 4, the mesh sheet 5, and the release film 6 (without the through-hole 6b) were laminated, as illustrated in Fig. 7E. Test Example 5 and Test Example 6 are examples in which steps 1 to 5 described above were performed, as illustrated in Fig. 7F. Test Example 8 is an example in which, as illustrated in Fig. 7G, the elastic member 3, the pressure-sensitive adhesive layer 4, the mesh sheet 5, and the release film 6 are laminated, and this laminated structure is laminated on the circuit pattern 2 while remaining in a sheet shape (that is, steps 1 to 4 described above were performed).

In addition, in the comparative example and Test Examples 1 to 7, the circuit pattern 2 has a thickness of 1 mm, and a width (gap) of the gap portion 2b is 0.8 mm. In addition, in Comparative Example 1 and Test Examples 1 to 7, the elastic member 3 is made of polyurethane foam, and has a thickness of 5 mm, a density of 80 kg/m³, and a 25% compressive stress of approximately 0.05 MPa. Note that, in Test Examples 2 to 6, the thickness of the elastic member 3 received in the gap portion 2b (when the pressure-sensitive adhesive layer 4 is provided, the thickness of the elastic member 3 including the pressure-sensitive adhesive layer 4) is 80% of the depth of the gap portion 2b (the thickness of the circuit pattern 2). In addition, in Test Examples 1 to 5, the pressure-sensitive adhesive layer 4 is a composite layer composed of an acrylic resin layer and a silicone resin layer (the acrylic resin layer being positioned on the elastic member 3 side), the pressure-sensitive adhesive strength on the silicone resin layer side is 0.11 N/25 mm, and the thickness is 20 µm. Note that the pressure-sensitive adhesive strength of the pressure-sensitive adhesive layer 4 is a value measured by a method substantially in accordance with JIS Z 1528. Specifically, a pressure-sensitive adhesive layer 4 backed with a PET sheet having a thickness of 100 µm on the acrylic resin layer side is prepared, the pressure-sensitive adhesive layer 4 is placed on a stainless steel sheet (which is placed in a direction where the silicone resin layer comes into contact with the stainless steel sheet), and a rubber roller having a mass of 2 kg is reciprocated once to bond them, and after one minute, the force required when pulled at a peel angle of 180° and a speed of 300 mm/min (the temperature at measurement being 23°C and the humidity being 50% RH) is measured. In Test Examples 6 and 7, the pressure-sensitive adhesive layer 4 has the same material and pressure-sensitive adhesive strength as in Test Examples 1 to 5, and has a thickness of 85 µm. In addition, in Test Examples 3 to 6, the mesh sheet 5 is a nonwoven fabric containing PET fibers having a melting point of 260°C. Note that the thickness of the mesh sheet 5 varies within a plane of the sheet, and a minimum thickness is 150 µm, a maximum thickness is 200 µm, and an average thickness is 175 µm. Then, in Test Examples 4 to 7, the release film 6 is a PET film having one surface (a surface opposite to the mesh sheet 5) surface-treated with a silicone-based release agent to impart peelability, and has a thickness of 75 µm.

In Test Examples 2 to 6, step 5 was performed by establishing a vacuum atmosphere inside a vacuum press apparatus and pressurizing the metal plate 23 illustrated in Fig. 4 with a hot plate (at a temperature of 180°C). The pressing force at the time of pressurization is 15 MPa, and the pressurization time is 13 minutes. The cushion material 21 (see Fig. 4) used in step 5 is composed of a main body formed of heat-resistant fibers (the basis weight of the main body being 1000 g/m²) and fluorine-based films provided on both surfaces of the main body, and has an overall thickness of 1.9 mm (0.2 kg/cm² at the time of pressurization). In addition, the resin sheet 22 (see Fig. 4) is a PET sheet, and has a thickness of 100 µm. Then, the metal plate 23 is made of SUS.

In forming the insulating layer 13, a bisphenol A epoxy resin (manufactured by DIC Corporation) was prepared as a thermosetting resin, diethyltoluenediamine (manufactured by Lonza Group AG) was prepared as a curing agent, aluminum oxide, an aggregate of boron nitride, and a fine powder of boron nitride were prepared as fillers, triphenylphosphine (manufactured by Hokko Chemical Industry Co., Ltd.) was prepared as a curing accelerator, and ethyl 3-ethoxypropionate was prepared as a solvent.

The thermosetting resin and the curing agent were then stirred at 70°C for 11 hours to form a prepolymer state (step 6). Subsequently, the above-described fillers, curing accelerator, and solvent were blended with the thermosetting resin in the prepolymer state and mixed with a mixer to produce a resin composition in a semi-cured state (step 7).

The produced resin composition was then applied on an elongated PET sheet and heated at 80°C for 40 minutes (step 8). Thereafter, the PET sheet coated with the resin composition was cut into a predetermined size (step 9). Thereafter, the cut sheet material was heated at 80°C for 20 minutes (step 10).

The sheet material after step 10 was then overlaid over the metal base substrate 12 so that the resin composition was in contact with the metal base substrate 12, and those were placed inside the vacuum press device. The overlaid sheet material and metal base substrate were then pressed at 23 MPa for 30 seconds in a vacuum atmosphere inside the device at 90°C (step 11).

Next, the PET sheet was peeled from the resin composition in a semi-cured state, which has been transferred onto the metal base substrate 12, and furthermore, the above-described composite bodies 1 of the comparative example and Test Examples 1 to 6 were overlaid to form a pre-press-bonding laminate (step 12).

Thereafter, as illustrated in Fig. 6A, the pre-press-bonding laminate is placed on a main body of an autoclave and covered with a film. After a lid body of the autoclave was then closed, an inside atmosphere the film was exhausted to increase the pressure and temperature inside the autoclave (step 13).

In step 13, the temperature inside the autoclave is maintained at 190°C (the temperature of the pre-press-bonding laminate being 160°C) for 13 minutes. The internal pressure at this time is 1.8 MPa.

Next, the elastic member and the like were removed from the laminate taken out from the autoclave (step 14), and thereafter heating was performed at 185°C under a non-pressurized (atmospheric pressure) condition for 1 hour (step 15). Thereafter, cleaning was performed and a predetermined inspection was performed (step 16).

Then, a withstand voltage test was conducted on the laminate manufactured through the above-described steps. The results are as illustrated in Table 1. In the laminates using the composite bodies 1 of Test Examples 1 to 7, the withstand voltage was 3 kV or more, and the result was favorable. The laminates using the composite bodies 1 of Test Examples 2 to 7 exhibited a withstand voltage of 5 kV or more, and the results were particularly favorable. The laminates using the composite bodies 1 of Test Examples 5 and 6 exhibited a withstand voltage of 9 kV or more, and the results were even more favorable. On the other hand, in the comparative example, when the elastic member 3 was removed in step 14, the elastic member 3 adhered to the resin composition 13A, resulting in a damage on the resin composition 13A. Thus, the withstand voltage could not be measured. In addition, in the comparative example, the elastic member 3 that was in contact with the circuit pattern 2 sometimes adhered to the circuit pattern 2, and it was sometimes necessary to perform an operation of removing the elastic member 3 adhering to the circuit pattern 2. In addition, in Test Example 3, although the withstand voltage was favorable, the mesh sheet 5 sometimes slightly adhered to the resin composition 13A, and the peelability when removing the elastic member 3 was sometimes impaired. Note that, also in the laminate using the composite body in which the pressure-sensitive adhesive layer 4 was omitted from Test Example 7 illustrated in Fig. 7G, the results of withstand voltage and peelability were favorable.

**[Table 1]**

| | Configuration | Withstand voltage | Peelability |
|---|---|---|---|
| Comparative Example | Fig. 7A | Not Measurable | X |
| Test Example 1 | Fig. 7B | 3kV | ○ |
| Test Example 2 | Fig. 7C | 5kV | ○ |
| Test Example 3 | Fig. 7D | 7kV | Δ |
| Test Example 4 | Fig. 7E | 7kV | ○ |
| Test Example 5 | Fig. 7F | 9kV | ○ |
| Test Example 6 | Fig. 7F | 10kV | ○ |
| Test Example 7 | Fig. 7G | 8kV | ○ |

Although one embodiment of the present invention has been described above, the present invention is not limited to the specific embodiment, and various modifications and changes can be made within the scope of the gist of the present invention described in the claims unless otherwise limited in the above description. In addition, the effects of the above embodiment are merely examples of the effects caused by the present invention, and the effects according to the present invention are not limited to the above effects.

For example, in step 5 described above, the elastic member 3 is relatively pressed against the circuit pattern 2 in a state where surroundings are in a vacuum atmosphere and at a predetermined temperature by using a vacuum press apparatus; however, this step may be performed by using an autoclave employing a film. In addition, in step 13, although the resin composition was cured by an autoclave employing a film, it may be performed by using a vacuum press apparatus. When using a vacuum press apparatus, the pressure inside the apparatus is preferably set higher than in a case of using the autoclave, and is preferably set to, for example, 1 to 10 MPa.

In addition, instead of the mesh sheet 5 and the release film 6 included in the composite body 1, a glass cloth impregnated with a fluororesin may be used. The glass cloth is a sheet in which glass fibers are arranged to form a mesh. The glass cloth impregnated with the fluororesin has peelability and air permeability. When such a glass cloth impregnated with a fluororesin was used instead of the mesh sheet 5 and the release film 6, it was confirmed that effects similar to those obtained when using the mesh sheet 5 and the release film 6 were achieved.

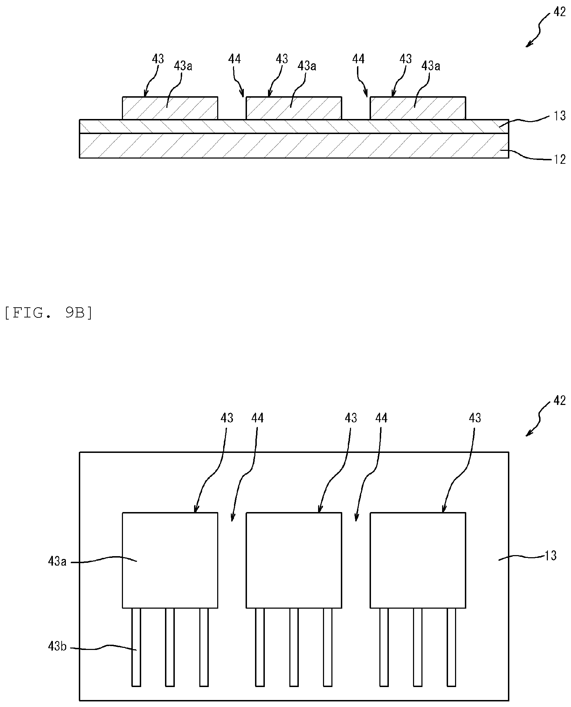

The circuit pattern 2 included in each of the composite body 1 and the laminate 11 may be a plurality of electronic components having a thickness of 0.5 mm or more. A composite body 41 illustrated in Fig. 8 and a laminate 42 illustrated in Figs. 9A and 9B have configurations corresponding to those of the composite body 1 illustrated in Fig. 1 and the laminate 11 illustrated in Fig. 2, and include a plurality of electronic components 43 instead of the circuit pattern 2 included in the composite body 1 and the laminate 11.

The electronic components 43 are, for example, used as high-brightness LEDs or power semiconductors (for example, an insulated gate bipolar transistor (IGBT), a metal-oxide-semiconductor field-effect transistor (MOSFET), or diodes). In the present embodiment, the electronic components 43 are obtained by sealing the above-described circuit pattern 2 (having, for example, a thickness of 2.0 mm) on which chip components, wiring, and the like are provided with a synthetic resin, and an outer thickness at a portion sealed with the synthetic resin is 0.5 mm or more. Note that, although there is no particular limitation on an upper limit of the outer thickness of the electronic component 43, it is, for example, 5.0 mm or less. As illustrated in Fig. 9B, the electronic component 43 of the present embodiment includes three external terminals 43b extending outward from a central portion in a thickness direction of a side surface of a main body portion 43a having a rectangular parallelepiped shape. The external terminals 43b are, for example, emitter electrodes, collector electrodes, base electrodes, source electrodes, drain electrodes, or gate electrodes in a case where the electronic component 43 is a power semiconductor. Although not illustrated, a lower terminal having a function of dissipating heat generated in the electronic component 43 to the outside may be provided on a lower surface of the main body portion 43a.

As illustrated, the composite body 41 and the laminate 42 of the present embodiment include three electronic components 43, and gap portions 44 are provided between adjacent electronic components 43. Note that the plurality of electronic components 43 (three electronic components 43 in the present embodiment) are a type of "electrical member" in the present specification and the like, and each of the electronic components 43 is a type of "circuit portion" in the present specification and the like.

Such a composite body 41 and a laminate 42 can also be obtained by performing the above-described steps 1 to 16. Also in the composite body 41 and the laminate 42 using the electronic components 43, various tests relating to the composite body 1 and the laminate 11 using the circuit pattern 2 (tests using the configurations illustrated in Figs. 7B to 7G and modifications thereof) were conducted, and it was confirmed that similar results were obtained.

Note that, in the composite bodies 1 and 41 illustrated in Figs. 1 and 8, the elastic member 3, the pressure-sensitive adhesive layer 4, the mesh sheet 5, and the release film 6 have sizes slightly larger than the size of the circuit pattern 2 or the size of the plurality of electronic components 43 taken together. Accordingly, a portion of the elastic member 3 and the like is received in not only the gap portions 2b and 44 but also disposed on the outer sides of the conductive portion 2a and the electronic components 43. However, the elastic member 3 and the like may be configured such that only a portion thereof is received in only the gap portions 2b and 44. That is, the size of the elastic member 3 and the like may be smaller than in the illustrated example, and may be a size that covers an entirety of the gap portion 2b included in the circuit pattern 2 or an entirety of the gap portion 44 located between the plurality of electronic components 43.

### Reference Signs List

- 1: Composite body
- 2: Circuit pattern (electrical member)
- 2a: Conductive portion (circuit portion)
- 2b: Gap portion
- 3: Elastic member
- 4: Pressure-sensitive adhesive layer
- 5: Mesh sheet
- 5a: First opening
- 6: Release film
- 6a: Second opening
- 6b: Through-hole
- 11: Laminate
- 11A: Pre-press-bonding laminate
- 12: Metal base substrate
- 13: Insulating layer
- 43: Electronic component (electrical member, circuit portion)
- 44: Gap portion

## Claims

1. A composite body comprising:
an electrical member including a circuit portion and a gap portion, and having a thickness of 0.5 mm or more; and
an elastic member disposed on one surface side of the electrical member in a state where a portion of the elastic member is received in the gap portion.

2. The composite body according to claim 1, further comprising a mesh sheet laminated on the portion of the elastic member received in the gap portion.

3. The composite body according to claim 2, further comprising a release film laminated on an other surface side of the electrical member with respect to the mesh sheet.

4. The composite body according to claim 3, wherein the release film has a through-hole communicating with the mesh sheet.

5. A composite body comprising:
an electrical member including a circuit portion and a gap portion, and having a thickness of 0.5 mm or more;
an elastic member disposed on one surface side of the electrical member; and
a pressure-sensitive adhesive layer laminated on an other surface side of the electrical member with respect to the elastic member.

6. A composite body comprising:
an electrical member including a circuit portion and a gap portion, and having a thickness of 0.5 mm or more;
an elastic member disposed on one surface side of the electrical member; a mesh sheet having a first opening corresponding to the circuit portion, and disposed on an other surface side of the elastic member in a state where the circuit portion is inserted through the first opening and received in the gap portion; and
a release film having a second opening corresponding to the circuit portion, and disposed on an other surface side of the mesh sheet in a state where the circuit portion is inserted through the second opening and received in the gap portion.

7. The composite body according to claim 6, further comprising a pressure-sensitive adhesive layer disposed between the elastic member and the mesh sheet.

8. A method for manufacturing a composite body, the method comprising:
a step of preparing an electrical member including a circuit portion and a gap portion, and having a thickness of 0.5 mm or more;
a step of arranging an elastic member on one surface side of the electrical member; and
a step of relatively pressing the elastic member against the electrical member in a state where surroundings are in a vacuum atmosphere and at a predetermined temperature, and allowing a portion of the elastic member to be received in the gap portion.

9. The method for manufacturing a composite body according to claim 8, the method further comprising:
a step of preparing a mesh sheet having a first opening corresponding to the circuit portion; and
a step of laminating the mesh sheet on an other surface side of the electrical member with respect to the elastic member, the laminating being performed before the step of allowing a portion of the elastic member to be received in the gap portion.

10. The method for manufacturing a composite body according to claim 9, the method further comprising:
a step of preparing a release film having a second opening corresponding to the circuit portion; and
a step of laminating the release film on the other surface of the electrical member with respect to the mesh sheet, the laminating being performed before the step of allowing a portion of the elastic member to be received in the gap portion.

11. The method for manufacturing a composite body according to claim 10, the method further comprising a step of forming a through-hole in the release film at a location different from the second opening, the forming a through-hole being performed before the step of laminating the release film.

12. A method for manufacturing a laminate in which a metal base substrate, an insulating layer formed by curing a resin composition, and an electrical member having a circuit portion and a gap portion and having a thickness of 0.5 mm or more are laminated, the method comprising:
a step of laminating the resin composition in a semi-cured state on the metal base substrate;
a step of laminating a composite body manufactured by the method for manufacturing a composite body according to any one of claims 8 to 11 on the resin composition in a semi-cured state to prepare a pre-press-bonding laminate;
a step of curing the resin composition in a semi-cured state in a state where surroundings of the pre-press-bonding laminate are in a vacuum atmosphere and at a predetermined temperature; and
a step of removing at least the elastic member of the pre-press-bonding laminate to form the laminate.

13. A method for manufacturing a laminate in which a metal base substrate, an insulating layer formed by curing a resin composition, and an electrical member having a circuit portion and a gap portion and a thickness of 0.5 mm or more are laminated, the method comprising:
a step of preparing a pre-press-bonding laminate in which the metal base substrate, the resin composition in a semi-cured state, the electrical member, a pressure-sensitive adhesive layer, and an elastic member are laminated in this order;
a step of curing the resin composition in a semi-cured state in a state where surroundings of the pre-press-bonding laminate are in a vacuum atmosphere and at a predetermined temperature; and
a step of removing at least the elastic member to form the laminate.

14. A method for manufacturing a laminate in which a metal base substrate, an insulating layer formed by curing a resin composition, and an electrical member including a circuit portion and a gap portion and having a thickness of 0.5 mm or more are laminated, the method comprising:
a step of preparing a mesh sheet having a first opening corresponding to the circuit portion;
a step of preparing a release film having a second opening corresponding to the circuit portion;
a step of preparing a pre-press-bonding laminate in which the metal base substrate, the resin composition in a semi-cured state, the electrical member, the release film positioned at a position where the second opening is received in the circuit portion, the mesh sheet positioned at a position where the first opening is received in the circuit portion, and an elastic member are laminated in this order;
a step of curing the resin composition in a semi-cured state in a state where surroundings of the pre-press-bonding laminate are in a vacuum atmosphere and at a predetermined temperature; and
a step of removing at least the elastic member to form the laminate.

15. The method for manufacturing a laminate according to claim 14, wherein the pre-press-bonding laminate further includes a pressure-sensitive adhesive layer disposed between the elastic member and the mesh sheet.
